# EUROPEAN PATENT APPLICATION

(11) **EP 4 391 748 A1**
(43) Date of publication of application: **26.06.2024**
(21) Application number: 23000182.8
(22) Date of filing: 22.12.2023
(51) Int. Cl.: H05K 7/14

(54) **APPARATUS FOR CONNECTING INDUSTRIAL DEVICES TO A DATA NETWORK AND RELATED COMMUNICATION SYSTEM**

(30) Priority: 23.12.2022 IT 202200026709
(71) Applicant: Pizzato Elettrica S.r.l., 36063 Marostica (Vicenza) (IT)
(72) Inventor: Pizzato, Giuseppe, 36063 Marostica (VI) (IT)
(74) Representative: Dalla Rosa, Silvia

(57) **Abstract**

An apparatus (**10**) for connecting industrial devices to a data network comprises a protective case (**11**), communication and safety means (**13, 15**) housed in the protective case (**11**) and suitable for receiving and/or transmitting signals of a safe and/or non-safe type from/to one or more industrial devices and to be connected to the data network to transmit thereto electrical signals relating to the operation of the one or more industrial devices, one or more operation connectors (**26**) associated with said protective case (**11**) in a removable way and suitable for each being connected to at least one or more industrial devices, connection means (**17**) connected to the operation connectors (**26**) and to the communication and safety means (**13, 15**) to allow the communication of the latter with industrial devices.

## Description

### Technical Field

The present invention deals with an apparatus for connecting industrial devices, of safe and non-safe type, to a data network and which may find application, in way of an example but without limits to generality, in the industrial automation sector wherein a machine or a plant are associated with some industrial devices and wherein it is necessary to monitor, or control, them by means of signals transmitted via a data network.

### State of the art

In the field of industrial machines and plants, and more specifically in the industrial automation sector, it is known to associate a machine or a plant to one or more industrial devices which are auxiliary, or necessary, for a user to operate or monitoring the machine or plant.

Some examples of these devices are safety devices such as safety interlocks, mechanical, magnetic or RFID safety switches, emergency mushrooms and other similar ones. In other cases, an industrial machine or plant may also be associated with unsafe devices, i.e. which do not perform safety functions, such as light or sound indicators, buttons, sensors and other similar devices.

Normally, the choice of the devices, whether safety or non-safe, to be associated with a machine or plant strongly depends on the features of the latter and its specific application. In this context, apparatuses, or gateways, are known to connect such devices to a data network connected to a control PLC associated with the machine or plant.

Generally, the known apparatuses are used to simplify wiring and for increasing the level of control and diagnostics on the devices connected thereto thorough the communication with the data network, which is normally an Ethernet type network. Communication takes place using known industrial communication protocols, of safe or non-safe type, such as ProfiNET^{®}/ProfiSAFE^{®}, I/O link, Ethernet IPTM, CIP SafetyTM and others. Typically, known apparatuses have a flattened "strip" shape with a series of female or male connectors on one of their surfaces which are then associated with the male or female connectors of the devices to be connected to the data network.

In turn, the connectors of known apparatuses are soldered to an electronic printed circuit board (PCB) comprising the electronic control and communication logic connected to the data network.

Although the use of these known devices has become increasingly widespread in recent years, they present some drawbacks.

A drawback of known apparatuses is represented by the fact that the range of devices that can be connected thereto is necessarily limited to those compatible with the connectors already installed in the apparatus.

This makes known equipment poorly adaptable compared to the wide range of devices available on the market and, therefore, not suitable of fully satisfying the customization needs of the end user.

US 2018/113428 A1 and US 2002/142630 A1 disclose a known apparatus having a plurality of connectors fixedly connected to the case and to the electronic printed circuit board which do not fully satisfy the customization needs of the end user. Furthermore, the apparatuses of US 2018/113428 A1 and US 2002/142630 A1 does not allow the reliable transmission to a data network of signals associated with safety conditions of the machine or plant.

As matter of fact, the devices available on the market, whether safe or non-safe, and which can be associated with machines or industrial plant may be supplied with a wide range of male connectors which currently includes at least 5 different types, For example, the connectors may have 4, 5, 8, 12 or 19 poles, with different shapes, and their selection depends on the type of device to which they belong, on its manufacturer, on the market in which it is sold and also on the specific industrial sector in which the device is designed for.

Therefore, there is a need to provide an apparatus for connecting safety devices which can overcome the drawback of prior art apparatuses.

### Scope of the invention

The object of the present invention is to overcome the above-mentioned drawbacks by providing an apparatus for connecting industrial devices to a data network which can be easily customized according to market demands.

Another object of the present invention is to provide an apparatus for connecting industrial devices to a data network which can be easily connected to a wide range of devices while being cost-effective and simple to manufacture.

These objects, as well as others that will become more apparent hereinafter, are achieved by an apparatus for connecting one or more industrial devices to a data network according to claim 1, to which reference is made for greater conciseness of the explanation. Advantageous embodiments of the apparatus are obtained in accordance with the dependent claims.

### Brief disclosure of the drawings

Further features and advantages of the invention will be more apparent in light of the detailed description of a preferred but not exclusive embodiment of the apparatus, illustrated by way of example and not by way of limitation with the aid of the attached drawing tables wherein:
**Fig. 1** is a top view of an apparatus according to a first embodiment;
**Fig. 2** is a side sectional view of the apparatus of Fig. 1;
**Figs. 3, 4** and **5** are front views of an apparatus according to three further different embodiments;
**Fig. 6** is a schematic representation of one embodiment of a system comprising the apparatus.

### Best modes of carrying out the invention

An apparatus **10** according to the present invention is designed to connect one or more industrial devices of an industrial machine or plant to a data network connected, in turn, to an external user. By way of example, the disclosed industrial devices may be safety devices such as safety interlocks, mechanical, RFID or magnetic switches, light barriers, emergency mushrooms, or similar. Alternatively, or additionally, the devices may be of an unsafe type such as buttons, light indicators, sound indicators and the like. Furthemore, always by way of example, the cited external user may be an industrial PLC or a safety module, or other similar devices for control of the machine or plant.

The apparatus **10** of the present invention comprises a protective case **11** housing an electronic control cardboard **12** provided with communication and safety means connected to connection means **17,** as will be detailed below, for receiving and/or transmitting safe and/or non-safe control signals from the industrial devices and designed to be connected to the data network to transmit electrical signals relating to the operation of the industrial devices.

The communication and safety means comprise a communication unit **13** and a safety unit **15** which will be described in detail below.

The protective case **11** is preferably box-shaped and comprises both a plurality of walls **19** defining a containment compartment **20** having an access opening **21,** and a cover **22** which is at least partially removable and suitable for allowing or blocking access to the containment compartment **20** from the access opening **21.**

The electronic cardboard **12** comprises first electrical connections to electrically connect the communication unit **13** to the connection means **17** and second electrical connections to connect the communication unit **13** with the safety unit **15.**

Furthermore, the electronic cardboard **12** comprises at least one safety electrical connection that connects the connection means **17** to the safety unit **15.**

In the present example, the first electrical connections comprise first conductive tracks **23** which connect the connection means **17** to the communication unit **13,** the second electrical connections comprise one or more second conductive tracks **24** which connect the communication unit **13** to the safety unit **15** and the safety electrical connection comprises at least one safety conductive track **25** which connects the connection means **17** to the safety unit **15.**

A person skilled in the art easily understands that the electrical connections just described may also be made using any other electrical connection clement such as, for example, an electrical wire, an electrical bridge or other similar elements.

The communication unit **13** is designed to be connected to an industrial data network to transmit and receive electrical signals relating to the operation of the apparatus **10** and of the industrial devices connected thereto. In this regard, the communication unit **13** may comprise communication connectors (not shown), for example a receiving connector and a communication connector. By way of example, the communication unit **13** is an electronic module suitable for being connected to an industrial PLC via an Ethernet network and designed to communicate via the ProfiNet ^{®} communication protocol, or via the Ethernet IPTM protocol.

The safety unit **15** is designed to communicate with the communication unit **13** and to receive at least one safe signal, i.e. relating to safety functions of an industrial machine or plant, from the connection means 17 via the electronic safety connection. Furthermore, the safety unit **15** is designed to transmit a coding signal for encoding said safe signal to the communication unit **13.**

Preferably, the safety unit **15** is designed to generate a safe payload **P** encoding the safe signal and to transmit the safe payload **P** to the communication unit **13.** The safe payload **P** comprises a bit sequence comprising, in turn, at least safety bits encoding the information contained in the safe signal and validation bits related to the safety bits and/or to safe payloads **P'** previously generated by the safety unit **15** and designed to guarantee the integrity and correctness of the information transmitted by the safe payload **P.** For example, the validation bits may comprise a check value generated via CRC (*Cyclic redundancy check*), an address corresponding to the safety device that transmits the safe signal, and/or a consecutive numerical value of the safe payloads previously generated by the safety unit **15.**

For example, an industrial safety device adapted to monitor a safety condition of the machine, and comprising safe outputs of the OSSD type (Output signal switching device) to signal whether the machine is safe or not, may be connected to the safety unit **15** via the connection means **17** and the safety electrical connection. In this case, the safe signal received by the safety unit **15** may substantially correspond to the state of the safe OSSD outputs and the safety unit **15** is designed to generate a safe payload **P** wherein the safety bits are related to the signal transmitted by the OSSD safe outputs.

In this way, the safety unit **15** encodes the information relating to a safety condition of the industrial machine or plant contained in the safe signal transmitted by the industrial device into a safe payload **P** which can be reliably transmitted to a non-safe data network. In fact, the structure of the safe payload **P** which comprises the safety bits and the validation bits guarantees the integrity of the safe payload **P** even during transmissions over a non-safe data network.

The communication unit **13** is designed to transmit the safe payload P received from the safety unit **15** to the data network.

Preferably, the communication unit **13** is also designed to generate and transmit non-safe payloads encoding the information contained in the non-safe signals received from industrial devices. Furthermore, the communication unit **13** is also designed to transmit the non-safe payloads to the data network.

Preferably, but not necessarily, the communication between the safety unit **15** and the communication unit **13** is carried out via the ProfiSAFE ^{®} secure communication protocol, or via the CIP SafetyTM secure protocol.

In addition, the coding signal which encodes said safe signal transmitted from the safety unit **15** to the communication unit **13** may also be transmitted from said communication unit **13,** via the safe communication protocol ProfiSAFE ^{®}, or via the safe CIP Safety protocol, on the Ethernet communication network.

In some embodiments of the present invention the safety unit **15** and the communication unit **13** are separated and independent from each other. In other possible embodiments of the present invention, the safety unit **15** and the communication unit **13** may be integrated into a single module or into a single electrical circuit.

The apparatus **10** also comprises a power supply section, which is not shown and not disclosed in greater details, and which may be separated from the electronic cardboard **12,** or incorporated thereinto, and which may also comprise respective power connectors, also not shown.

The apparatus **10** also comprises at least one operation connector **26** connected to the connection means **17** and suitable for allowing the connection of industrial devices to the electronic cardboard **12.**

Preferably, the apparatus **10** comprises a plurality of operation connectors **26** to allow the simultaneous connection of more than one device to the electronic cardboard **12.** For example, the apparatus **10** comprises more than four operation connectors **26,** preferably more than five operation connectors **26,** even more preferably at least six operation connectors **26.**

According to a further aspect, at least one operation connector **26** is removably fixed to the protective case **11.** Preferably, each operation connector **26** is removably fixed to the protective case **11.**

In the example of the figures, each operation connector **26** is fixed at a respective hole made on one of the walls **19** of the protective case **11.**

In particular, according to the preferred but not exclusive embodiment of the figures, all the operation connectors **26** will be associated with a same wall **19,** although they may also be associated with different walls.

Furthermore, according to a preferred but not exclusive embodiment, each hole may be designed to allow the insertion and stable and removable fixing of any of the suitably provided operative connectors **26.**

To this end, the holes and the operation connectors **26** will be provided respectively with first and second coupling means, complementary with each other, wherein the first coupling means are similar to each other and the second coupling means are similar to each other.

By way of example, the holes may be through holes and have a smooth internal profile and the operation connectors **26** may have a threaded surface on which a nut may be associated, which nut being adapted to be screwed to said external threaded surface to abut against the inner surface of the wall **19** and hold the operation connector **26** into position. Alternatively, each hole may have an internal threaded edge suitable for coupling with an external thread made on the working connectors **26.**

Furthermore, according to a not shown configurations, the mutual coupling means could be of the interlocking, joint, bayonet type or, furtherly, one or more internal plates may be provided and firmly placed in the protective case **11** and designed to stably but removably lock the operation connectors **26.**

However, according to further embodiments, not shown, at least some of said operation connectors **26** may be fixed to a plate which, in turn, is removably fixed to the protective case **11,** for example to a wall **19** of the protective case **11.**

Advantageously, this allows different types of operation connector **26** to be associated with the electronic cardboard **12** depending on the customization required by an end user without modifying the shape and dimensions of the protective case **11.** In this way, the apparatus **10** of the present invention may mount a wide range of different operation connectors **26** in an interchangeable manner and therefore it may be connected to a wide range of industrial devices satisfying the needs of the market.

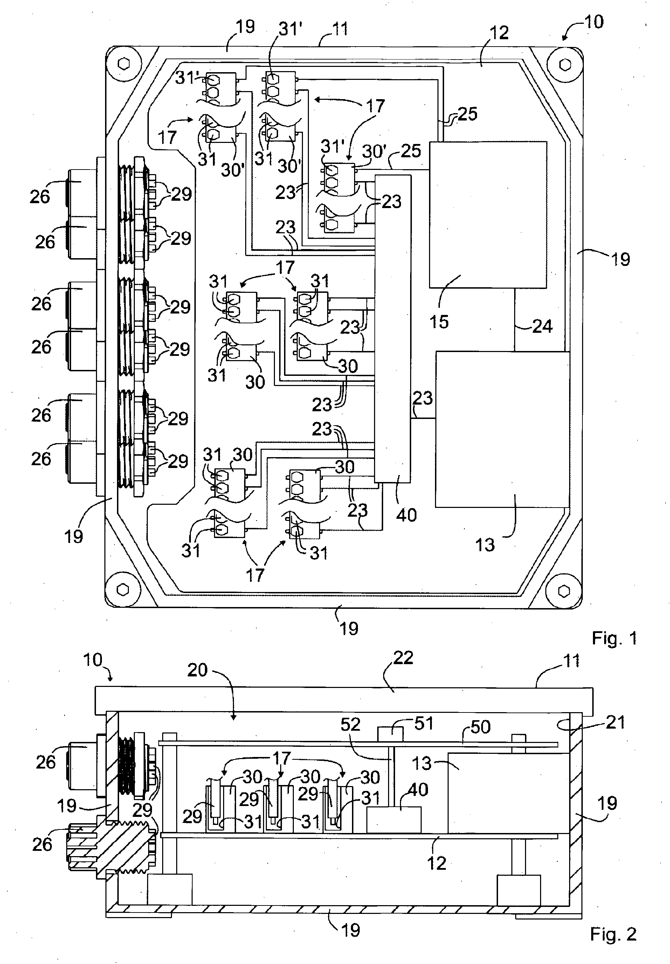

Each operation connector **26** is preferably connected to the connection means **17** by means of a respective bundle of electrical wires **29.** It should be noted that in **Figs. 1** and **2** the electrical wires **29** are only partially represented for simplicity of explanation. Furthermore, it is also specified that each operation connector **26** may comprise a male or female connection end connected to the bundle of electrical wires **29.** Alternatively, an operation connector **26** may be made up only by the bundle of electrical wires **29** connected directly to an industrial device and from a cable gland, not shown, associated with a hole made on a wall **19** of the protective case **11.**

By way of example, in a possible embodiment, not shown in the figures, the connection means **17** may comprise a plurality of connection areas, each of which comprises a plurality of soldering pads designed to allow the soldering of an electric wire **29.** Preferably, but not necessarily, the number of soldering pads of each connection area is greater than or equal to the number of electrical wires **29** of each operation connector **26** that can be connected thereto. Each soldering pad is connected to a conductive track **23, 25** to allow the transmission of an electrical signal from the respective electrical wire **29** to the respective conductive track **23, 25.**

In addition, in this embodiment, the apparatus **10** comprises at least one contact area having at least one solder pad electrically connected to the electrical safety connection.

Advantageously, this arrangement makes the apparatus very flexible to be produced and suitable of fully satisfying the customization needs of the market. In fact, the connection between the operation connectors **26** and the soldering pads allows a single type of electronic cardboard **12** to be combined with a wide range of operation connectors **26** depending on the configuration requested by the end user.

In accordance with a preferred embodiment, at least one of said operation connectors **26** is connected to said connection means **17** in a removable and reversible manner. Preferably, all the operation connectors **26** are connected to the connection means **17** in a removable and reversible manner.

It should be noted that the terms "removable and reversible" referring to a connection, here and below, mean that the connection may be easily reversed, i.e. that it can easily return to its initial state and conditions. More precisely, a removable and reversible connection does not consist of a solder.

Advantageously, this allows different types of operation connector **26** to be associated with the electronic cardboard **12** depending on the customization required by an end user without invasively intervening on the electronic cardboard. In this way, the apparatus **10** of the present invention may interchangeably mount a wide range of different operation connectors **26** and therefore may be connected to a wide range of industrial devices, satisfying the needs of the market.

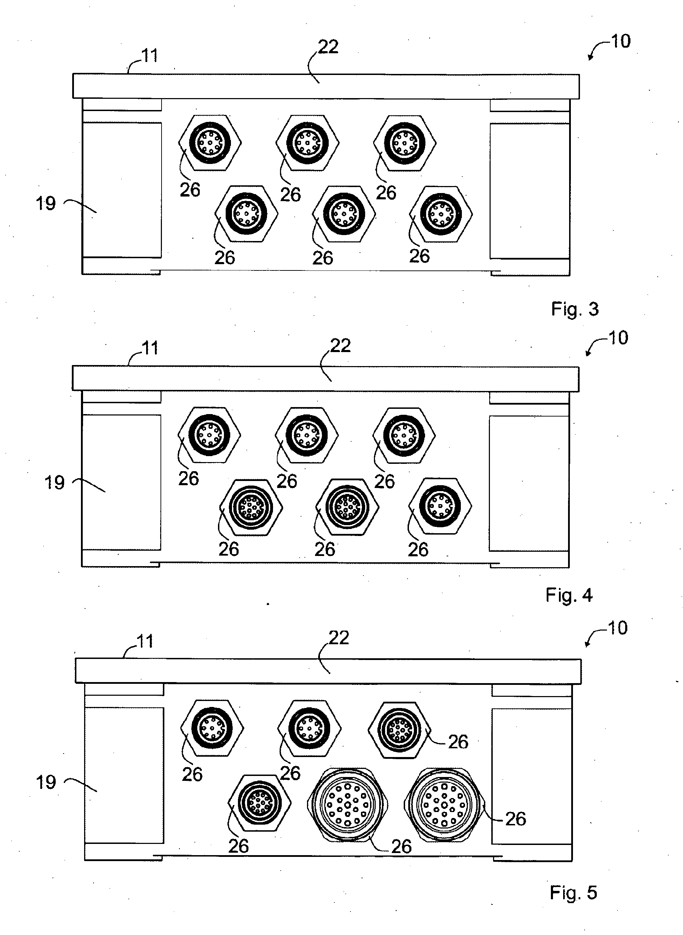

A further advantage of the apparatus **10** of the present invention consists in the fact that its production is very flexible, easy and fast and suitable of fully satisfying the customization needs of the market. In fact, the removable and reversible connection between the operation connectors **26** and the connection means **17** allows a single type of electronic cardboard **12** to be combined with a wide range of working connectors **26** depending on the configuration requested by the end user. This allows to significantly reduce production times and costs. By way of not limiting example, **Figs. 3** to **5** show some possible examples of customizations that can be obtained with the apparatus **10** here disclosed, which essentially differ in the type of operation connectors **26.** It is noted that the customizations of Figs. 3 to 5 are provided only as an example and are not to be understood as limiting the scope of protection of the present invention.

According to the preferred embodiment illustrated, the connection means **17** comprise at least one terminal block **30, 30'** designed to provide a removable and reversible electrical and mechanical connection with the electrical wires **29** of an operation connector **26.** The presence of the terminal blocks **30, 30'** will be particularly advantageous for increasing the flexibility of use of the apparatus as the connection between the operation connectors **26** and the electronic cardboard **12** will be reversible.

Preferably, the connection means **17** comprise more than one terminal block **30, 30',** for example more than four terminal blocks **30, 30',** preferably more than five terminal blocks **30, 30',** even more preferably at least six terminal blocks **30, 30'.**

Each terminal block **30, 30'** comprises a plurality of seats **31, 31'** for receiving a respective electric wire **29.** In each seat **31, 31'** there are locking and unlocking elements, not shown, designed both to mechanically retain an end of the electric wire **29** and to provide an electrical contact therewith. Furthermore, each seat **31, 31'** is also associated with a conductive element, not shown, designed to allow the transmission of an electrical signal from the electrical wire **29** to a conductive track **23, 25.**

Preferably, but not necessarily, the number of seats **31, 31'** of each terminal block **30, 30'** is greater than or equal to the number of electrical wires **29** of each operation connector **26** that can be connected thereto.

According to a further aspect, the apparatus **10** may comprise at least one terminal block **30'** having at least one seat **31'** electrically connected to the electrical safety connection. In the present example, the connection means **17** comprise three distinct terminal blocks **30',** each of which comprises a respective seat **31'** connected to a respective safety conductive track **25.**

It should be noted that the connection means **17** may comprise further terminal blocks **30** connected only to said first electrical connections. In the present example, the connection means **17** comprise three terminal blocks **30** connected only to the first conductive tracks **23.**

Optionally, the apparatus **10** may also comprise a reading and writing unit **40** connected to the connection means **17** and to the communication unit **13** and designed to periodically sample the signals outgoing from the connection means **17** and transmit a single signal to the communication unit **13** encoding all the signals received from the connection means **17** for each sampling period.

Moreover, the reading and writing unit **40** may also be designed to periodically sample the signals coming from the communication unit **13** and simultaneously transmit a signal to the connection means **17** encoding the signal received from the communication unit **13** for each sampling period.

Advantageously, the reading and writing unit **40** is connected to the first electronic connections and simplifies the connection between them and the communication unit **13.** In the present example, the reading and writing unit **40** is connected to the first conductive tracks **23** and comprises shift register circuits connected to the connection means **17** and to a microprocessor connected directly to the communication unit **13.**

Advantageously, this allows for a reduced number of conductive tracks connected to the communication unit **13.**

Optionally, the apparatus **10** also comprises a control panel **50** connected to the communication unit **13** and comprising a control member **51** which allows a user to select an identification code of the apparatus **10,** for example associated with the safety unit **15.** In this case, the communication unit **13** is also adapted to associate said identification code with the signals transmitted to the data network.

In this present case, the control member **51** comprises one or more dip switches connected via a respective connection member **52** to the reading and writing unit **40** and therefore to the communication unit **13.**

In the preferred embodiments, the control panel **50** is arranged between the electronic cardboard **12** and the cover **22** when this latter is positioned to close the access opening **21** of the containment compartment **20.** In addition, the control panel **50** has a transverse size such as to substantially completely cover the electronic cardboard **12** and prevent a user from reaching the electronic cardboard **12** even when the cover **22** is removed from the protective case **11.**

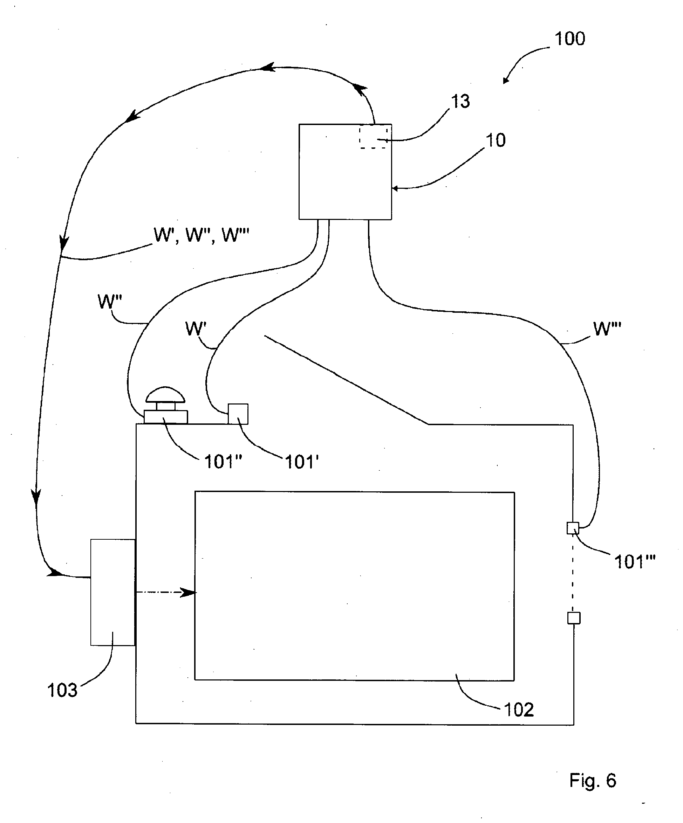

With reference to **Fig. 6****,** a communication system **100** for industrial devices **101** is shown, which communication system **100** comprising an apparatus **10** of the type described above and one or more iindustrial devices **101** independent from said apparatus **10,** i.e. not integrated in the latter, and associated with a machine or to an industrial plant **102.** Each of said industrial devices **101** is connected to a respective operation connector **26** of the apparatus **10** to transmit a respective working signal **W** thereto. Furthermore, the apparatus **10** is designed to transmit a coding signal encoding each of said working signals **W** to a data network. By way of example, said data network may be connected to a control PLC, or control unit, **103** of the machine **102** or of the plant which, therefore, is designed to control the machine **102** or the plant according to said working signals **W** received from said apparatus **10.**

By way of example, these industrial devices **101** can may be selected from a group comprising: electronic safety switches **101',** safety interlocks, optical barriers **101‴,** pushbutton panels, mushroom emergency buttons 101‴ and the like.

Preferably, at least one of said industrial devices **101** is associated with safe functions of said machine or plant. Even more preferably, the control unit **103** is adapted to control the machine **102,** i.e. to allow or disallow its operation, depending on the safe payload **P.** This embodiment allows the use of a single apparatus **10,** and therefore a single communication unit **13** and a single safety unit **15** for the connection of a plurality of industrial devices **101,** significantly reducing the costs for the communication system. Preferably, the number of said independent industrial devices **101** connected to said apparatus **10** is greater than or equal to three.

## Claims

1. An apparatus (10) for connecting industrial devices, associated with an industrial machine or plant, to a data network comprising at least one control unit of said industrial machine or plant, said apparatus (**10**) comprising:
- a protective case (**11**);
- communication and safety means (**13, 15**) housed in said protective case (**11**) and suitable for receiving and/or transmitting safe and/or non-safe signals from/to one or more industrial devices and for being connected to the data network to transmit thereto electrical signals relating to the operation of one or more industrial devices;
- one or more operation connectors (**26**) associated with said protective case (**11**) and each suitable for being connected to at least one of the one or more industrial devices;
- connection means (**17**) connected to said one or more operation connectors (**26**) and to said communication and safety means (**13, 15**) to allow the communication of the latter with said one or more industrial devices;
**characterized in that** at least one of said one or more operation connectors (**26**) is fixed to said protective case (**11**) in a removable manner.

2. Apparatus (10) as claimed in claim 1, **characterized in that** said communication and safety means comprise:
- a communication unit (**13**) suitable to be connected to the data network and to transmit thereto electrical signals relating to the operation of said at least one industrial device; and
- a safety unit (**15**) connected to said connection means (**17**) to receive and/or transmit at least one safe type signal relating to safety functions of said industrial machine or plant from said at least one industrial device, designed to generate a safe payload (**P**) encoding said safe signal and transmit the latter to said communication unit (**13**);
said communication unit (**13**) further being adapted to transmit said sae payload (**P**) to said data network.

3. Apparatus (**10**) as claimed in claim 1 or 2, **characterized in that** said communication unit (**13**) is further connected to said connection means (**17**) to receive and/or transmit exclusively signals of a non-safe type from said at least one industrial device.

4. Apparatus (**10**) as claimed in claim 1, 2 or 3, **characterized in that** at least one of said one or more operation connectors (**26**) is connected to said connection means (**17**) in a removable and reversible manner.

5. Apparatus (**10**) as claimed in claim 3 or 4, **characterized by** comprising first electrical connections between said connection means (**17**) and said communication unit (**13**), second electrical connections between said communication unit (**13**) and said safety unit (**15**) and at least one electrical safety connection between said connection means (**17**) and said safety unit (**15**).

6. Apparatus (**10**) as claimed in any claim from 2 to 5, **characterized in that** at least one of said one or more operation connectors (**26**) comprises a bundle of electrical wires (**29**), said connection means (**17**) comprising one or more terminal blocks (**30, 30'**) having a plurality of seats (**31, 31'**) each of which is designed to receive a respective electrical wire of said bundle (**29**) in a removable and reversible manner.

7. Apparatus (**10**) as claimed in claim 6, **characterized in that** said connection means (**17**) comprise at least one terminal block (**30'**) having at least one seat (**31'**) electrically connected to said electrical safety connection.

8. Apparatus (**10**) as claimed in claim 7, **characterized in that** said connection means (**17**) comprise at least one terminal block (**30**) having the respective seats (**31**) electrically connected only to said first electrical connections.

9. Apparatus (**10**) as claimed in any claim from 4 to 8, **characterized in that** said connection means (**17**), said communication unit (**13**) and said safety unit (**15**) are associated with an electronic cardboard (**12**) comprising first conductive tracks (**23**) between said connection means (**17**) and said communication unit (**13**), second conductive tracks (**24**) between said communication unit (**13**) and said safety unit (**15**) and at least one safety conductive track (**25**) between said connection means (**17**) and said safety unit (**15**).

10. Apparatus (**10**) as claimed in any claim from 4 to 9, **characterized in that** it further includes a reading and writing unit (**40**) designed to periodically sample the signals coming from said connection means (**17**) and transmit a coding signal to said communication unit (**13**) encoding the signals received by said connection means (**17**) in a sampling period.

11. Apparatus (**10**) as claimed in claim 10, **characterized in that** said reading and writing unit (**40**) is also designed to periodically sample the signals coming from said communication unit (**13**) and to transmit a signal to said means of connection (**17**) encoding the signals received by said communication unit (**13**) in a sampling period.

12. Apparatus (**10**) as claimed in any claim from 2 to 11, **characterized by** comprising a control panel (**50**) having a control member (**51**) connected to said communication unit (**13**) and suitable to allow a user to select an identification code, said communication unit (**13**) further being adapted to associate said identification code with the signals transmitted to said data network.

13. Apparatus (**10**) as claimed in claim 12, **characterized in that** said protective case (**11**) has a lateral surface formed by a plurality of walls (**19**) and having an access opening (**21**) associated with a cover (**22**) at least partially removable, said control panel (**50**) being placed between said electronic board (**12**) and said cover (**22**) and having such a size as to prevent access to said electronic cardboard (**12**) when said cover (**22**) is at least partially removed to allow access to the inside of said protective case (**11**).

14. Apparatus (**10**) as claimed in claim 13, **characterized in that** one or more of said walls (**19**) are provided with one or more holes for the removable insertion of respective of said operation connectors (**26**), said holes and said working connectors (**26**) being provided respectively with first and second mutual coupling means complementary to each other, wherein said first coupling means are similar to each other and said second coupling means are similar to each other to allow the coupling of each of said operation connectors (**26**) to any of said holes.

15. Apparatus (**10**) as claimed in any claim from 2 to 14, **characterized in that** said communication unit (**13**) is separate and independent with respect to said safety unit (**15**).

16. Apparatus (**10**) as claimed in any claim from 2 to 12, **characterized in that** said communication unit (**13**) and said safety unit (**15**) are integrated into a single electrical circuit.

17. Apparatus (**10**) as claimed any preceding claim, **characterized in that** said connection means (**17**) comprise a plurality of connection areas, each of which is associated with an operation connector (**26**) and comprises a plurality of soldering pads.

18. Apparatus (**10**) as claimed in any preceding claim, **characterized in that** said safe payload (**P**) comprises security bits coding the information contained in said safe signal and validation bits related to said security bits and/or safe payloads previously sent and designed to guarantee the integrity of said safe payload (**P**).

19. Communication system (**100**) for industrial devices (**101', 101", 101‴**) comprising:
- at least one apparatus (**10**) as in any of the previous claims;
- one or more industrial devices (**101', 101", 101‴**) independent from said apparatus (**10**) and associated with a machine or an industrial plant (**102**),
- a data network;
wherein each of said industrial devices (**101', 101", 101‴**) is connected to a respective work connector (**26**) of said at least one apparatus (**10**) to transmit a respective working signal (**W', W", W‴**) thereto and
wherein said apparatus (**10**) is suitable for transmitting each of said working signal (**W', W", W‴**) to said data network.

20. Communication system as claimed in claim 19, **characterized in that** at least one of said industrial devices (**101', 101", 101‴**) is associated with safe functions of said machine or plant.

21. Communication system as claimed in claim 19 or 20, **characterized in that** said data network is connected to a control PLC (**103**) of said machine or plant (**102**) designed, in turn, to control said machine or plant according to said working signal (**W', W", W‴**) received by said apparatus (**10**) and to allow or not the operation of said machine (**102**) or plant based on said safe payload (**P**).

22. Communication system as claimed in claim 19, 20 or 21, **characterized in that** the number of said independent industrial devices (**101', 101", 101‴**) connected to said apparatus (**10**) is greater than or equal to three.
